# EUROPÄISCHE PATENTANMELDUNG

(11) **EP 3 712 965 A1**
(43) Veröffentlichungstag der Anmeldung: **23.09.2020**
(21) Anmeldenummer: 20000113.9
(22) Anmeldetag: 17.03.2020
(51) Int. Cl.: H01L 31/0687, H01L 31/0304

(54) **STAPELFÖRMIGE, MONOLITHISCHE, AUFRECHT METAMORPHE, TERRESTRISCHE KONZENTRATOR-SOLARZELLE**

(30) Priorität: 22.03.2019 DE 102019002034
(71) Anmelder: AZUR SPACE Solar Power GmbH, 74072 Heilbronn (DE)
(72) Erfinder: Fuhrmann, Daniel, 74081 Heilbronn (DE); Guter, Wolfgang, 70190 Stuttgart (DE); Meusel, Matthias, 74076 Heilbronn (DE)
(74) Vertreter: Koch Müller Patentanwaltsgesellschaft mbH

(57) **Zusammenfassung**

Stapelförmige, monolithische, aufrecht metamorphe, terrestrische Konzentrator-Solarzelle mit genau fünf Teilzellen und mit einem metamorphen Puffer, wobei eine erste Teilzelle eine erste Gitterkonstante G1 aufweist und aus Germanium besteht, eine zweite Teilzelle eine zweite Gitterkonstante und GaInAs aufweist, eine dritte Teilzelle die zweite Gitterkonstante G2 und AlGaInAs aufweist, eine vierte Teilzelle die zweite Gitterkonstante G2 und (Al)GaInP aufweist, eine fünfte Teilzelle die zweite Gitterkonstante G2 und AlGaInP aufweist, für die Gitterkonstanten gilt G1 < G2, der metamorphen Puffer zwischen der ersten Teilzelle und der zweiten Teilzelle angeordnet ist und an einer der ersten Teilzelle zugewandten Unterseite die erste Gitterkonstanten G1 und an einer der zweiten Teilzelle zugewandten Oberseite die zweite Gitterkonstante G2 aufweist, alle über der ersten Teilzelle angeordneten Halbleiterschichten der Konzentrator-Solarzelle auf der jeweils Vorausgehenden epitaktisch erzeugt sind.

## Beschreibung

Die Erfindung betrifft eine stapelförmige, monolithische, aufrecht metamorphe, terrestrische Konzentrator-Solarzelle mit genau fünf Teilzellen und mit einem metamorphen Puffer.

Zur besseren Ausnutzung des Sonnenspektrums umfassen Mehrfachsolarzellen im Allgemeinen drei oder mehr Teilzellen mit unterschiedlichen, aufeinander abgestimmten Bandlücken, wobei die oberste Teilzelle die größte Bandlücke und die unterste Teilzelle die kleinste Bandlücke aufweist und sich die oberste Teilzelle auf der Sonnen-zugewandten Seite der Mehrfachsolarzelle befindet.

Mehrfachsolarzellen sind beispielsweise aus der DE 10 2015 016 047 A1, der EP 2 779 253 A1 und der US 2012 / 0 216 858 A1 bekannt.

Die oberste Teilzelle einer Mehrfachsolarzelle, im Folgenden auch als Oberzelle bezeichnet, besteht bei gitterangepassten Mehrfachsolarzellen auf Germanium-Substrat häufig aus InGaP mit einem Bandabstand von ca. 1,88 eV.

Die InGaP Oberzelle zeigt eine offene Klemmenspannung V_{oc} von etwa 1,4 V auf. Zur Erhöhung der Effizienz von Mehrfachsolarzellen werden sowohl metamorphe als auch gitterangepasste Konzepte mit mehr als drei Teilzellen verfolgt.

Um höhere Wirkungsgrade zu erzielen, ist die Verwendung von MehrfachSolarzellen mit 4 Teilzellen inzwischen obligatorisch. Bei der aufrecht metamorphen AlGaInP/AlGaInAs/GaInAs/Ge Vierfach-Solarzelle, auch als UMM bezeichnet, besteht jedoch das Problem, dass die zur Erhöhung der Bandlücke notwendige Verwendung von größeren Mengen Aluminium in den oberen beiden Teilzellen zu einer Verschlechterung der Materialeigenschaften und hierdurch zur Verringerung der Solarzelleffizienz führt. Aufgrund der geringen Miinoritätsladungsträger-Lebensdauer ist z.B. die Differenz zwischen offener Klemmspannung (Voc) und Energiebandlücke (Eg) deutlich höher als z.B. bei gitterangepassten GaAs und GaInP Solarzellen.

Zusätzlich führt die Verwendung von Aluminium in der obersten Teilzelle zu einer Reduktion der Beweglichkeit der Majoritätsladungsträger im Emitter der obersten Teilsolarzelle und damit zu einer deutlichen Erhöhung des Schichtwiderstands in der Mehrfachsolarzelle. Der vorgenannte Effekt ist bei Konzentratorsolarzellen, die typisch bei Konzentrationsfaktoren von 500-fach - 1000-fach betrieben werden, äußerst relevant. Hier führt schon ein leicht erhöhter Serienwiderstand, z.B. um den Faktor 2, zu einer deutlichen Reduktion der Effizienz der Mehrfachsolarzelle unter Konzentration.

Hierdurch sind z. B. die AlGaInP/AlGaInAs/GaInAs/Ge Vierfach-Solarzelle mit einer Al-haltigen Oberzelle bisher für die Raumfahrtanwendung entwickelt worden. Die Anforderungen an den Schichtwiderstand sind durch die fehlende Konzentration des Solarlichtes wesentlich geringer als unter Konzentration, sodass Serienwiderstandsverluste weniger Auswirkungen auf den Gesamtwirkungsgrad der Mehrfachsolarzelle haben.

Zusätzlich degradiert die Weltraumsolarzelle während ihres Einsatzes im Weltraum durch die dort auftreffende hochenergetische Partikelstrahlung bestehend aus Elektronen und Protonen ohnehin, sodass auch eine geringere Minoritätsladungsträger-Lebensdauer am Anfang der Mission (beginning-of-life, BOL) durch eine reduzierte Materialqualität für die Al-haltigen Materialen im Vergleich zu den bisher verwendeten Al-freien Oberzellen auf den entscheidenden end-of-life (EOL) Wirkungsgrad am Ende der Mission weniger auswirkt.

Aus der Druckschrift "About AZUR's 3G30-advanced Space Solar Cell and Next Generation Product with 35% Efficiency" von Strobl et al., ISBN 3-936338-28-0, ist beispielsweise eine solche aufrecht metamorphe AlGaInP/AlGaInAs/GaInAs/Ge Vierfach-Solarzelle für die Raumfahrtanwendung bekannt. Eine entsprechende Mehrfachsolarzelle ist aus dem Vortrag "Development of Upright Metamorphic 4J Space Solar Cells", von W. Guter et al., Space Power Workshop 2017, Manhattan Beach, CA bekannt.

Weiterhin ist aus der Druckschrift "European Roadmap for the Development of III-V Multi-junction Space Solar Cells" von Meusel et al., Proc. of 19th EU-PVSEC, Paris, 2004, p.3581-3586, ist eine gitterangepasste fünffach-Solarzelle für die Raumfahrtanwendung mit der Materialkombination AlGaInP/GaInP/AlGaInAs/GaInAs/Ge bekannt.

Aus der Druckschrift "Experimental Results from Performance Improvement and Radiation Hardening of Inverted Metamorphic Multi-Junction Solar Cells" von Patel et al., IEEE Journal of Photovoltaics, July 2012, ist eine invertiert metamorphe Fünffach-Solarzelle für die Raumfahrtanwendung bekannt. Die Energiebandlücken der Teilzellen sind 0,89 eV, 1,13 eV 1,43 eV, 1,74 eV und 2,05 eV, wobei die oberen beiden Teilzellen aus gitterangepassten Materialen gebildet werden.

Insbesondere bei der Verwendung von InAlGaP Oberzellen im Vergleich zu der Al-freien InGaP Oberzelle ist jedoch nachteilig, dass hier im Vergleich zu einer InGaP Oberzelle ein ca. fünffach höherer Schichtwiderstand auftritt. Dieser führt in der Mehrfachsolarzelle für CPV Anwendungen, d.h. bei Konzentratoranwendungen, bei höheren Strömen im Ampere Bereich zu größeren Serienwiderstandsverlusten.

So ist aus der Druckschrift "Progress toward an advanced four-subcell inverted metamorphic multi-junction (IMM) solar cell" von Wanlass et al., Prog. Photovolt: Res. Appl. 2016, 24: 139 - 149 DOI: 10.1002/pip.2609 bekannt, das bei AlInGaP Solarzellen der Füllfaktor schon bei Konzentrationen oberhalb von 10-facher Sonnenkonzentration aufgrund der Serienwiderstandsverluste im InAlGaP-Material deutlich abnimmt.

Weiterhin ist aus der Druckschritt "Evolution of a 2.05 eV AlGaInP Top Subcell for 5 and 6J-IMM Applications" von Cornfeld et al., 2012 38th IEEE Photovoltaic Specialists Conference, 10.1109/PVSC.2012.6318171, bekannt, dass die offene Klemmspannung V_{oc} der obersten Teilzelle einer gestapelten Mehrfachsolarzelle durch Zugabe von Al erhöht werden kann. Dabei wird allerdings die Materialqualität durch die Zugabe von Al deutlich verschlechtert, sodass die Diffusionslänge der Minoritätsladungsträger abnimmt. Gleichzeitig erhöht sich der Serienwiderstand, was schon bei Messung für Anwendungen mit dem Konzentrationsfaktor eins zur Reduktion des Füllfaktors für Al-haltige Solarzellen führt.

Für Konzentratoranwendungen, d.h. CPV Anwendungen, müssen die Verluste für hohe Ströme jedoch möglichst gering gehalten werden. Eine alternative Möglichkeit zur Reduktion höherer Serienwiderstandsverluste besteht darin, den Abstand zwischen den Metallfingern auf der Oberseite der InAlGaP Oberzelle gegenüber der InGaP Oberzelle deutlich zu reduzieren. Zwar lassen sich die Widerstandsverluste hierdurch prinzipielle ausgleichen, jedoch führt der Ansatz zu einer höheren Abschattung und hierdruch ebenfalls zu einer Verringerung des Wirkungsgrads der gesamten Solarzelle.

Gerade bei CPV-Anwendungen, d.h. Konzentratoranwendungen mit einem Faktor 100 und höher, ist deshalb auf eine ausreichende Querleitfähigkeit zu achten, um die Abschattungsverluste durch die vielen Metallfinger, d.h. Gridfinger, so klein wie möglich zu halten. Hierbei weisen CPV-Anwendungen Konzentrationsfaktoren im Allgemeinen zwischen 500 und 1500 auf.

Das Konzept einer metamorphen Mehrfachsolarzelle mit mehr 3 Teilzellen ist hierdurch nicht für Konzentratoranwendungen geeignet.

Durch die Erhöhung der Gitterkonstante durch den metamorphen Puffer reduziert sich die Bandlücke aller In-haltlgen Teilzellen.

Unabhängig vom angewendeten Mehrfachsolarzellkonzept wird dennoch eine Oberzelle mit hoher Bandlücke für eine hohe Gesamteffizienz benötigt. Auch für aufrecht-metamorphe Solarzellen lässt sich dies durch Zugabe von Al realisiert werden, jedoch muss der Al-Gehalt durch den im Vergleich zu gitterangepassten Konzepten oder invertiert-metamorphen Konzepten höheren In-Gehalt der Oberzelle noch wesentlich höher gewählt werden, um eine vergleichbare Bandlücke zu erreichen.

Der höhere Al-Gehalt der Oberzelle führt jedoch zu einer zusätzlichen Verstärkung der bei Al-haltigen Oberzellen auftretenden Probleme hinsichtlich des Schichtwiderstandes und der Materialqualität.

Vor diesem Hintergrund besteht die Aufgabe der Erfindung darin, eine Vorrichtung anzugeben, die den Stand der Technik weiterbildet.

Die Aufgabe wird durch eine Vorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige, monolithische, aufrecht metamorphe, terrestrische Konzentrator-Solarzelle mit genau fünf Teilzellen und mit einem metamorphen Puffer bereitgestellt.

Eine erste Teilzelle weist eine erste Gitterkonstante G1 und eine erste Bandlücke B1 auf und besteht aus Germanium.

Eine zweite Teilzelle ist über der ersten Teilzelle angeordnet und weist eine zweite Gitterkonstante G2 und eine zweite Bandlücke B2 auf und umfasst eine Verbindung aus GaInAs oder besteht aus GaInAs.

Eine dritte Teilzelle ist über der zweiten Teilzelle angeordnet und weist die zweite Gitterkonstante G2 und eine dritte Bandlücke B3 auf und umfasst AlGaInAs oder besteht aus AlGaInAs.

Eine vierte Teilzelle ist über der dritten Teilzelle angeordnet und weist die zweite Gitterkonstante G2 und eine vierte Bandlücke B4 auf und umfasst eine Verbindung aus InP.

Eine fünfte Teilzelle ist über der vierten Teilzelle angeordnet und weist die zweite Gitterkonstante G2 und eine fünfte Bandlücke B5 auf und umfasst InP.

Für die Bandlücken gilt B1 < B2 < B3 < B4 < B5 und für die Gitterkonstanten gilt G1 < G2.

Der metamorphen Puffer ist zwischen der ersten Teilzelle und der zweiten Teilzelle angeordnet und weist an einer der ersten Teilzelle zugewandten Unterseite die erste Gitterkonstanten G1 und an einer der zweiten Teilzelle zugewandten Oberseite die zweite Gitterkonstante G2 auf. Es versteht sich dass die erste Gitterkonstante G1 gleich 5,66 Ä ist, d.h. der Gitterkonstante von Ge entspricht.

Außerdem sind alle über der ersten Teilzelle angeordneten Halbleiterschichten der Konzentrator-Solarzelle auf der jeweils vorausgehenden Teilzelle epitaktisch erzeugt.

Die fünf Teilzellen und der metamorphe Puffer sind jeweils schichtförmig, also als Halbleiterschicht ausgebildet.

Zusammen bilden die Teilzellen und der metamorphe Puffer und gegebenenfalls weitere Schichten, z.B. Tunneldioden, einen Stapel aus.

Die erste Teilzelle ist beispielsweise als Substrat ausgebildet. Alle weiteren Halbleiterschichten, also insbesondere die vier weiteren Teilzellen und der metamorphe Puffer sind jeweils auf einer unmittelbar vorausgehenden Halbleiterschicht des Stapels epitaktisch erzeugt, z.B. mittels MOVPE oder mittels LPE oder MBE.

Insbesondere umfasst der Stapel der erfindungsgemäßen Konzentrator-Solarzelle keinen Halbleiterbond.

Es versteht sich, dass mit dem Begriff der Konzentrator Solarzelle vorliegend eine Mehrfachsolarzelle mit genau fünf Teilzellen verstanden wird, wobei die Solarzelle für Konzentratoranwendungen mit einem Konzentrationsfaktor oberhalb von 500 eingesetzt wird.

Es sei angemerkt, dass die jeweiligen Teilzellen als n über p-Teilzellen ausgebildet sind, d.h. die Teilzellen weisen jeweils eine n- -dotierte Emitterschicht und eine p- dotierte Basisschicht auf. Hierbei ist der Emitter vorzugsweise stoffschlüssig mit der Basis verbunden.

Auch sei angemerkt, dass zwischen zwei unmittelbar aufeinanderfolgenden Teilzellen eine Tunneldiode ausgebildet ist. Die zwischen der ersten und zweiten Teilzelle ausgebildete Tunneldiode lässt sich sowohl zwischen der ersten Teilzelle und dem metamorphen Puffer oder zwischen dem metamorphen Puffer und der zweiten Teilzelle anordnen.

Bevorzugt ist die Emitterschicht über der Basisschicht angeordnet, so dass Licht zuerst die Emitterschicht und dann Basisschicht durchdringt. Es versteht sich, dass die Tunneldioden jeweils aus einer dünnen hoch n-dotierten Schicht und einer dünnen hoch p-dotierten Schicht besteht und die beiden Schichten der Tunneldiode aufeinander angeordnet sind.

Weiterhin sei angemerkt, dass n-Emitter und p-Basis der jeweiligen Teilzellen vorzugsweise aus demselben Material, aber mit unterschiedlicher Dotierung besteht. Hierbei wird unter dem Begriff Material eine gegebene Verbindung aus III-V Elementen verstanden.

In alternativen Ausführungsformen weisen die Emitterschicht und die Basisschicht einer Teilzelle unterschiedliche III-V Verbindungen auf. Derartige Teilzellen werden als Heterozellen bezeichnet.

Ein Vorteil der erfindungsgemäßen Ausführung einer Mehrfachsolarzelle für Konzentrator-Anwendungen ist, dass durch die Verwendung des aufrechtmetamorphen Wachstums die gesamte 5-fach Solarzelle monolithisch in einem Wachstumsprozess hergestellt werden kann. Hierdurch lassen sich im Vergleich zu anderen Mehrfachsolarzell-Konzepten wie invertiert-metamorphen oder wafer-gebondenten Konzepten die Kosten wesentlich reduziert werden und die Prozessierung der epitaktisch abgeschiedenen Schichtstrukturen zu Solarzellen mit bisher etablierten Standard-Prozessen durchgeführen.

Ein Vorteil der Anordnung mit fünf Teilzellen ist es, dass bei der vierten Teilzelle kein Al oder Al nur unter 1% eingebaut ist.

Ein weiterer Vorteil der Anordnung mit fünf Teilzellen ist es, dass bei der fünften Teilzelle kein Al oder Al nur unter 5% oder Al nur unter 35% eingebaut ist, wobei dennoch ein geringer Schichtwiderstand insbesondere von kleiner als 1500 Ω/□ oder kleiner als 1000 Ω/□ erreicht wird.

Es wird angemerkt, dass der Ausdruck "bestehend aus" einem genannten Element oder einer genannten Verbindung von beispielsweise zwei, drei oder vier Elementen bedeutet, dass die entsprechende Halbleitersicht, z.B. Teilzelle, im Wesentlichen aus den genannten Materialien besteht bzw. neben den genannten Elementen gegebenenfalls noch Verunreinigungen und/oder Dotierstoffe, z.B. Zink oder Silizium oder Zinn oder Kohlenstoff, aufweist.

Der Ausdruck "umfassend" ein genanntes Element oder eine genannte Verbindung von Elementen, z.B. InP, bedeutet dahingegen, dass die Halbleiterschicht neben den ausdrücklich genannten Elementen gegebenenfalls weiteren Elementen, insbesondere weiteren Elementen der III. und / oder V. Hauptgruppe, z.B. Aluminium, aufweist bzw. umfasst, also aus einer Verbindung der genannten Elemente mit weiteren Elementen insbesondere der III. und / oder V. Hauptgruppe besteht. Eine InP aufweisende Halbleiterschicht, z.B. Teilzelle, schließt also beispielsweise eine InGaP-Schicht oder auch eine AlInGaP-Schicht ein.

Ein Vorteil der Ausbildung der ersten Teilzelle aus Germanium besteht darin, dass sich die erste Teilzelle einfach und kostengünstig beispielsweise durch Aktivierung eines Germanium Substrates mittels As- und / oder P-Diffusion während des Prozesses der metallorganischen Gasphasenepitaxie (MOVPE) herstellen lässt.

Insbesondere müssen für eine Ausbildung der ersten Teilzelle keine mehreren Mikrometer dicken Schichten aus Germanium, d.h. sogenannte Bulk-Schichten, zur Absorption der Photonen epitaktisch abgeschieden werden. Hierdurch weist die erste Teilzelle geringe Herstellungskosten auf.

Es versteht sich auch, dass herstellungsbedingte Schwankungen der Gitterkonstanten, insbesondere der zweiten Gitterkonstanten, über die Schichten bzw. Teilzellen vorliegen können bzw. die zweite Gitterkonstante von Schicht zu Schicht bzw. von Teilzelle zu Teilzelle zumindest geringfügig variieren kann. Anders ausgedrückt weichen die zweiten Gitterkonstanten der zweiten, dritten, vierten und fünften Teilzellen jeweils um weniger als 0,2% voneinander ab.

Außerdem wird angemerkt, dass bei der Konzentrator-Solarzelle ein Lichteinfall immer zuerst durch die fünfte Teilzelle erfolgt.

Ein Vorteil der erfindungsgemäßen Konzentrator-Solarzelle ist, dass Dank der Materialkombination einerseits das terrestrischen Sonnenspektrums besonders gut ausgenutzt wird und andererseits eine ausreichend hohe Querleitfähigkeit in den obersten Teilzellen gewährleistet ist. Hierzu lässt sich die zweite Gitterkonstante infolge des metamorphen Puffers von der Gitterkonstanten von Ge derart einstellen, dass auch bei hohen Strombelastungen infolge von Konzentrationsfaktoren oberhalb von 500 insbesondere die wenigen 100 nm dicke oberste Teilzelle, d.h. die fünfte Teilzeile, eine im Vergleich zu bisherigen Al haltigen Teilzellen eine wesentlich niederohmige Querleitfähigkeit aufweisen. Hierdurch steigt der Wirkungsgrad der gesamten Konzentratorzelle.

In einer ersten Ausführungsform weist die vierte Teilzelle und / oder die fünfte Teilzelle GaInP auf oder besteht aus GaInP.

In einer Weiterbildung weist die vierte Teilzelle einen Aluminium-Gehalt von 0% oder kleiner 3% oder kleiner 1% auf. Gemäß einer anderen Weiterbildung weist die fünfte Teilzelle einen Aluminium-Gehalt von kleiner als 10% oder kleiner als 25% oder kleiner als 35% auf, bezogen jeweils auf die Gruppe III Elemente.

Beispielsweise besteht die vierte Teilzelle aus GaInP und die fünfte Teilzelle aus AlGaInP mit einem entsprechend geringen Aluminium-Gehalt unter 10 % oder unter 25 % oder unter 35%, bezogen jeweils auf die Gruppe III Elemente.

Gemäß einer anderen Ausführungsform ist eine Schichtdicke der zweiten Teilzelle und/oder eine Schichtdicke der dritten Teilzelle größer als 1 µm und kleiner als 3,5 µm.

Eine Schichtdicke der vierte Teilzelle und / oder eine Schichtdicke der fünften Tellzelle ist vorzugsweise größer als 100 nm und kleiner als 1,5 µm.

In einer anderen Weiterbildung weist der metamorphe Puffer eine Abfolge von mindestens drei und höchstens zehn Schichten auf und / oder eine Schichtdicke von mindestens 0,5 µm und von höchstens 4 µm auf.

Der metamorphe Puffer ist bevorzugt hoch n-dotiert oder hoch p-dotiert und beispielsweise aus InGaAs ausgebildet.

Insbesondere weist die metamorphe Pufferschichtfolge bevorzugt eine Dotierstoffkonzentration größer als 5·10¹⁷ N/cm³ und eine Schichtdicke oberhalb 0,5 µm und kleiner als 20 µm auf.

In einer Ausführungsform besteht die metamorphe Puffer aus mehreren InₓGa₁₋ₓAs-Schichten mit sich von Schicht zu Schicht unterscheidendem und/oder gleichbleibendem x.

Es versteht sich, dass sich die Gitterkonstante innerhalb des Puffers mindestens einmal ändert. Gemäß einer ersten Ausführungsform nimmt die Gitterkonstante ausgehend von einer untersten Schicht der Abfolge mit der ersten Gitterkonstanten hin zu der obersten Schicht der Abfolge mit der zweiten Gitterkonstante von Schicht zu Schicht beispielsweise zu.

Alternativ nimmt die Gitterkonstante ausgehend von der untersten Schicht der Abfolge von Schicht zu Schicht zuerst zu und dann ab oder auch zuerst ab und dann zu. Die Zunahme oder die Abnahme der Gitterkonstanten über die gesamte Abfolge verläuft entweder stufenförmig oder linear oder auch in einer beliebigen anderen Form.

In einer anderen Ausführungsform weist die zweite Teilzelle eine Gitterkonstante größer 5,72·10⁻¹⁰ m, also größer 5,72 Å, und / oder eine Bandlücke größer 1,07 eV und/oder einen Indium-Gehalt kleiner als 24,5% auf.

Gemäß einer weiteren Ausführungsform weist die dritte Teilzelle eine Bandlücke zwischen 1,34 eV und 1,45 eV auf, oder zwischen oder 1,3 eV und 1,5 eV auf.

Die vierte Teilzelle weist bevorzugt eine Bandlücke zwischen 1,61 eV und 1,69 eV oder zwischen 1,58 eV und 1,72 eV auf.

Die fünfte Teilzelle weist bevorzugt eine Bandlücke zwischen 1,8 eV und kleiner als 2,05 eV oder kleiner als 1,98 eV und vorzugsweise größer als 1,75 eV auf.

Gemäß einer weiteren Weiterbildung weist die Konzentrator-Solarzelle eine Fensterschicht auf, wobei die Fensterschicht oberhalb der fünften Teilzelle angeordnet ist und eine um mindestens 0,5 % oder mindestens 0.7% geringere Gitterkonstante als die zweite Gitterkonstante aufweist. Die geringfügig verspannte Fensterschicht hilft eine möglichst optisch transparente Oberseite des Solarzellenstapels zu erreichen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigt:
- Figur 1: einen schematischen Querschnitt einer ersten erfindungsgemäßen Ausführungsform einer stapelförmigen Konzentrator-Solarzelle,
- Figur 2: einen schematischen Querschnitt einer zweiten erfindungsgemäßen Ausführungsform einer stapelförmigen Konzentrator-Solarzelle.

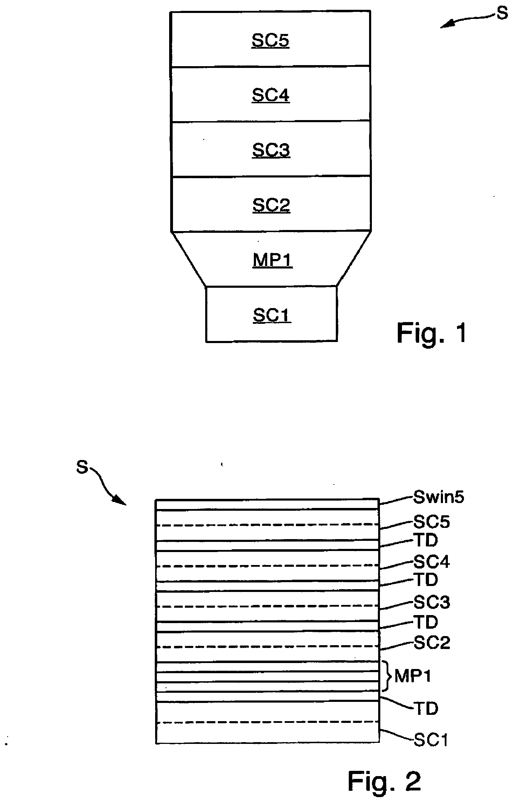

Die Abbildung der Figur 1 zeigt eine stapelförmige, monolithische, aufrecht metamorphe, terrestrische Konzentrator-Solarzelle S mit genau fünf Teilzellen SC1, SC2, SC3, SC4 und SC5 und mit einem zwischen der ersten Teilzelle SC1 und der zweiten Teilzelle SC2 angeordnetem metamorphen Puffer MP1.

Die erste Teilzelle SC1 besteht aus Germanium und weist eine entsprechende erste Gitterkonstante und eine erste Bandlücke auf. Die weiteren Teilzellen SC2, SC3, SC4, und SC5 weisen alle eine zweite Gitterkonstante G2 auf, wobei die zweite Gitterkonstante G2 größer als die erste Gitterkonstante G1 ist.

Der Übergang zwischen den beiden unterschiedlichen Gitterkonstanten G1 und G2 des Stapels wird mittels des metamorphen Puffers MP1 erreicht, wobei der metamorphe Puffer MP1 hierfür an einer der ersten Teilzelle SC1 zugewandten Unterseite die erste Gitterkonstante G1 und an einer der zweiten Teilzelle SC2 zugewandten Oberseite die zweite Gitterkonstante G2 aufweist.

Die Gitterkonstanten sind anhand der Breite der jeweiligen Halbleiterschicht veranschaulicht.

Die zweite, dritte, vierte und fünfte Teilzelle SC2, SC3, SC4 und SC5 weisen jeweils eine Bandlücke B2, B3, B4 bzw. B5 auf, wobei gilt B1 < B2 < B3 < B4 < B5.

In der Abbildung der Figur 2 ist eine weitere Ausführungsform dargestellt. Im Folgenden werden nur die Unterschiede zu der Abbildung der Figur 1 erläutert.

Jede Teilzelle SC1 bis SC5 der Konzentrator-Solarzelle S weist eine Emitterschicht und eine Basisschicht auf, die in der Figur 2 jeweils durch gestrichelte Linien angezeigt werden. Zwischen jeweils zwei aufeinanderfolgenden Teilzellen der Konzentrator-Solarzelle S ist außerdem jeweils eine Tunnediode TD angeordnet. Die zwischen der ersten Teilzelle SC1 und der zweiten Teilzelle SC2 angeordnete Tunneldiode TD ist unterhalb des metamorphen Puffers MP1 angeordnet.

Der metamorphe Puffer MP1 besteht aus einer Abfolge von drei Halbleiterschichten, wobei die untere Schicht die erste Gitterkonstante G1, die obere Schicht die zweite Gitterkonstante G2 und die mittlere Schicht eine dritte Gitterkonstante G3 mit G1 < G2 < G3 aufweist.

Gemäß nicht dargestellter alternativer Ausführungsformen umfasst die Abfolge mehr als drei Halbleiterschichten und / oder die Gitterkonstante nimmt von Schicht zu Schicht bis zu einem Maximum zu und anschließend von Schicht zu Schicht wieder bis zu dem Wert der zweiten Gitterkonstanten G2 ab.

Gemäß einer nicht dargestellten anderen Ausführungsform ist die zwischen der ersten Teilzelle SC1 und der zweiten Teilzelle SC2 angeordnete Tunneldiode TD oberhalb des metamorphen Puffers MP1 angeordnet.

## Patentansprüche

1. Stapelförmige, monolithische, aufrecht metamorphe, terrestrische Konzentrator-Solarzelle (S) mit genau fünf Teilzellen und mit einem metamorphen Puffer (MP1), wobei
- eine erste Teilzelle (SC1) eine erste Gitterkonstante G1 und eine erste Bandlücke B1 aufweist und aus Germanium besteht,
- eine zweite Teilzelle (SC2) über der ersten Teilzelle (SC1) angeordnet ist, eine zweite Gitterkonstante G2 und eine zweite Bandlücke B2 aufweist und GaInAs umfasst oder aus GaInAs besteht,
- eine dritte Teilzelle (SC3) über der zweiten Teilzelle (SC2) angeordnet ist, die zweite Gitterkonstante G2 und eine dritte Bandlücke B3 aufweist und AlGaInAs umfasst oder aus AlGaInAs besteht,
- eine vierte Teilzelle (SC4) über der dritten Teilzelle (SC3) angeordnet ist, die zweite Gitterkonstante G2 und eine vierte Bandlücke B4 aufweist und InP umfasst,
- eine fünfte Teilzelle (SC5) über der vierten Teilzelle (SC4) angeordnet ist, die zweite Gitterkonstante G2 und eine fünfte Bandlücke B5 aufweist und InP umfasst,
- für die Bandlücken gilt B1 < B2 < B3 < B4 < B5,
- für die Gitterkonstanten gilt G1 < G2,
- der metamorphen Puffer (MP1) zwischen der ersten Teilzelle (SC1) und der zweiten Teilzelle (SC2) angeordnet ist und an einer der ersten Teilzelle (SC1) zugewandten Unterseite die erste Gitterkonstanten G1 und an einer der zweiten Teilzelle zugewandten Oberseite die zweite Gitterkonstante G2 aufweist,
- alle über der ersten Teilzelle (SC1) angeordneten Halbleiterschichten der Konzentrator-Solarzelle (S) auf der jeweils vorausgehenden Teilzelle epitaktisch erzeugt sind
**dadurch gekennzeichnet, dass**
dass die fünfte Teilzelle (SC5) aus AlInGaP besteht, wobei der Indium-Gehalt größer als 63% ist, und einen Emitterschichtwiderstand kleiner als 1500 Ω/cm² oder kleiner als 1000 Ω/cm² aufweist.

2. Konzentrator-Solarzelle (S) nach Anspruch 1, **dadurch gekennzeichnet, dass** die vierte Teilzelle (SC4) und/oder die fünfte Teilzelle (SC5) GaInP aufweist oder aus GaInP bestehet.

3. Konzentrator-Solarzelle (S) nach Anspruch 2, **dadurch gekennzeichnet, dass** die vierte Teilzelle (SC4) und/oder die fünfte Teilzelle (SC5) eine Aluminium-Gehalt bezogen auf die Gruppe III Elemente von 0% oder kleiner 5% oder kleiner 1% aufweist.

4. Konzentrator-Solarzelle (S) nach einem der vorstehenden Ansprüche, **dadurch gekennzeichnet, dass** die fünfte Teilzelle (SC5) aus AlInGaP besteht und einen Indium-Gehalt größer als 63% und einen Aluminium-Gehalt kleiner als 25% oder kleiner als 37% jeweils bezogen auf die Gruppe III Elemente aufweist.

5. Konzentrator-Solarzelle (S) nach einem der vorstehenden Ansprüche, **dadurch gekennzeichnet, dass** die fünfte Teilzelle (SC5) als Heterozelle ausgeführt ist, wobei der Aluminium-Gehalt der Basis höher ist als der Aluminium-Gehalt des Emitters.

6. Konzentrator-Solarzelle (S) nach einem der vorstehenden Ansprüche, **dadurch gekennzeichnet, dass** die fünfte Teilzelle (SC5) als Heterozelle ausgeführt ist, wobei die Basis aus AlInGaP gebildet wird und der Emitter aus InGaP gebildet wird.

7. Konzentrator-Solarzelle (S) nach einem der vorstehenden Ansprüche, **dadurch gekennzeichnet, dass** eine Schichtdicke (S2) der zweiten Teilzelle (SC2) und/oder eine Schichtdicke (S3) der dritten Teilzelle (SC3) größer als 1 µm und kleiner als 5 µm ist.

8. Konzentrator-Solarzelle (S) nach einem der vorstehenden Ansprüche, **dadurch gekennzeichnet, dass** eine Schichtdicke (S4) der vierten Teilzelle (SC4) und/oder eine Schichtdicke (S5) der fünften Teilzelle (SC) größer als 100 nm und kleiner als 500 nm oder kleiner als 1,5 µm ist.

9. Konzentrator-Solarzelle (S) nach einem der vorstehenden Ansprüche, **dadurch gekennzeichnet, dass** der metamorphe Puffer (MP1) eine Abfolge von mindestens drei und höchstens zehn Schichten aufweist und / oder dass der metamorphe Puffer (MP1) eine Schichtdicke von mindestens 0,5 µm und von höchstens 4 µm aufweist.

10. Konzentrator-Solarzelle (S) nach einem der vorstehenden Ansprüche, **dadurch gekennzeichnet, dass** die zweite Teilzelle (SC2) eine Gitterkonstante größer 5,72·10⁻¹⁰) m aufweist und/oder eine Bandlücke größer 1,07 eV und/oder einen Indium-Gehalt kleiner 24,5%.

11. Konzentrator-Solarzelle (S) nach einem der vorstehenden Ansprüche, **dadurch gekennzeichnet, dass** die dritte Teilzelle (SC3) eine Bandlücke zwischen 1,34 eV und 1,45 eV oder 1,3 eV und 1,5 eV aufweist.

12. Konzentrator-Solarzelle (S) nach einem der vorstehenden Ansprüche, **dadurch gekennzeichnet, dass** die vierte Teilzelle (SC4) eine Bandlücke zwischen 1,61 eV und 1,69 eV oder 1,58 eV und 1,72 eV aufweist.

13. Konzentrator-Solarzelle (S) nach einem der vorstehenden Ansprüche, **dadurch gekennzeichnet, dass** die fünfte Teilzelle (SC5) eine Bandlücke < 2,05 eV oder kleiner als 1,98 eV und insbesondere größer als 1,74 eV aufweist.

14. Konzentrator-Solarzelle (S) nach einem der vorstehenden Ansprüche, **dadurch gekennzeichnet, dass** die Konzentrator-Solarzelle (S) eine Fensterschicht (SWin5) aufweist, wobei die Fensterschicht (Swin5) oberhalb der fünften Teilzelle (SC5) angeordnet ist und eine um mindestens 0,5 oder mindestens 0,7% geringere Gitterkonstante als die vierte Gitterkonstante (G4) aufweist.
